# EUROPEAN PATENT APPLICATION

(11) **EP 1 821 576 A1**
(43) Date of publication of application: **22.08.2007**
(21) Application number: 06003245.5
(22) Date of filing: 17.02.2006
(51) Int. Cl.: H05B 33/06, H05B 33/10, H01L 51/00

(54) **Electroluminescent display prepared by ink jet technology**

(71) Applicant: TETENAL AG & Co. KG., 22844 Norderstedt (DE)
(72) Inventor: De Rossi, Umberto, Dr., 22844 Norderstedt (DE)
(74) Representative: Becker Kurig Straus

(57) **Abstract**

The present invention pertains to the field of animated electroluminescent displays. In particular, the present invention provides an electroluminescent display, an ink for printing of a back electrode and an improved method for its preparation using common accessible devices, such as ink jet printers, and thereby facilitating the production process of electroluminescent displays and reducing costs.

## Description

The present invention pertains to the field of animated electroluminescent displays. In particular, the present invention provides an electroluminescent display, an ink for printing of a back electrode and an improved method for its preparation using common accessible devices, such as ink jet printers, and thereby facilitating the production process of electroluminescent displays and reducing costs.

Particular materials have electroluminescent (EL) properties. Such EL materials emit light in response to a strong electric field or to an electric current passed through. The first known electroluminescent materials were inorganic particulate substances such as ZnS, silicon, germanium or a semiconductor such as InP, GaAs, GaAlAs, GaP or GaN with suitable dopants. More recently-found electroluminescent materials include a number of small-molecule organic emitters known as organic LEDs (OLEDs) and some plastics- synthetic organic polymeric substances-known as light-emitting polymers (LEPs).

Inorganic particulates, in a doped and encapsulated form, are still in use, particularly when mixed into a binder and applied to a substrate surface as a relatively thick layer; LEPs can be used both as particulate materials in a binder matrix or, with some advantages, on their own as a relatively thin continuous film.

Such electroluminescent films are mainly composed of a stack of several layers between two transparent protective films, a layer formed from one or several front transparent electrodes, a dielectric layer, a layer comprising the electroluminescent material, a dielectric layer, a layer comprising one or several rear electrodes. The transparent electrode(s) are for example indium-tin oxide (ITO)-based electrodes. The electroluminescent layer is made from a semiconductive phosphor material, the metallic electrodes may be aluminium and the protective films are made from a transparent flexible material.

When a sufficient electrical voltage is applied between two electrodes located in the front and rear layers, the electroluminescent material becomes an emitting material and a visible image is formed, the outline of which corresponds to that of the rear electrodes. The colour of the emitted light depends on the phosphor material which is used. One active element is thus created per electrode. Several individually controlled elements may be combined in order to display information on a dashboard of a vehicle for example.

This electroluminescent effect has also been used in the construction of displays. In some types of these a large area of an electroluminescent material- generally referred to in this context as a phosphor- is provided to form a backlight which can be seen through a mask that defines whatever characters the display is to show. In other types there are instead individual small areas of EL material. These displays have many applications; examples are a simple digital time and date display (to be used in a watch or clock), a mobile phone display, the control panel of a household device (such as a dishwasher or washing machine), and a hand-holdable remote controller (for a television, video or DVD player, a digibox, or a stereo or music centre). They are widely applied in making advertising sign boards, signal boards, ornamental panels for motor vehicles or buildings and the like because of its advantageous features of light weight and emitting light without heat.

A general electroluminescent panel comprises a front electrode layer, a luminescent layer, a reflective layer, and a back electrode layer. In order to manufacture an electroluminescent panel for displaying desired letters, signs or pattern, the front electrode layer, the luminescent layer and the reflective layer are sequentially formed by performing a screen-printing process. Next, a screen plate having the desired letters, sign or pattern is used to print the desired letters, sign or pattern is placed onto the reflective layer, and then the back electrode layer is printed onto the reflective layer.

Such an electroluminescent panel is disclosed in US 2005/212417 and US 2004/160180. The second disclosure relates for example to electroluminescent panel comprising a front electrode layer; a luminescent layer, formed on the front electrode layer; a reflective layer, formed on the luminescent layer; a back electrode layer having at least a pattern or letters for being displayed by the electroluminescent panel; an insulating layer, adhered onto the back electrode layer. The insulating layer comprises a plurality of contact holes, and wherein the contact holes are disposed according to the pattern or letters of the back electrode layer.

In EP 1536471 an organic light emitting device for preventing element defects and improving picture quality by reducing a taper angle of a substrate surface is disclosed. The flat panel display of the present invention comprises an insulating substrate, a lower layer formed on the insulating substrate and having a first step and a first taper angle with respect to the substrate surface, and an upper layer formed on the insulating substrate and for reducing the taper angle of the lower layer. The upper layer has a second taper angle smaller than the first taper angle of the lower layer. The upper layer is a conductive layer that may be applied by a wet coating method, has a charge transporting capability, and is selected from at least one of a small-molecule organic layer.

Drawbacks of the above electroluminescent panels or displays reside, however, preliminary in production. If for example a particular design of electroluminescent panels is ordered, the manufacturer has to prepare a particular set of screen plates or layers. This renders the aforementioned process cost intensive for mass production for customers requiring electroluminescent panels for various purposes such as displaying e.g. letters, signs or patterns, independent of the required quantity of displays.

It is therefore an object of the present invention to provide an electroluminescent display and a production method, allowing a cost-saving and fast production of such displays.

The present inventors surprisingly found that the above objective may be solved by the provision of an electroluminescent display and a respective production method, relying preliminary on the use of ink jet (IJ) printing technology using common available printing devices, rendering at the same time the production of electroluminescent displays cost-effective and fast. The electroluminescent display according to the present invention provides several layers. In particular, a commercial available substrate serves as a base. On a first side of the substrate first a layer comprising an electroluminescent material (the electroluminescent layer) is disposed. Thereon, also a dielectric layer is disposed and a back electrode is ink jet printed. On the second side of the substrate an image is ink jet printed.

It was surprisingly found that by combination of conventional techniques for the preparation electroluminescent displays and applying basic and inexpensive materials with ink jet technology, in a particular ink jet printing, a screen/display may be produced comprising fewer parts and requiring shorter curing periods.

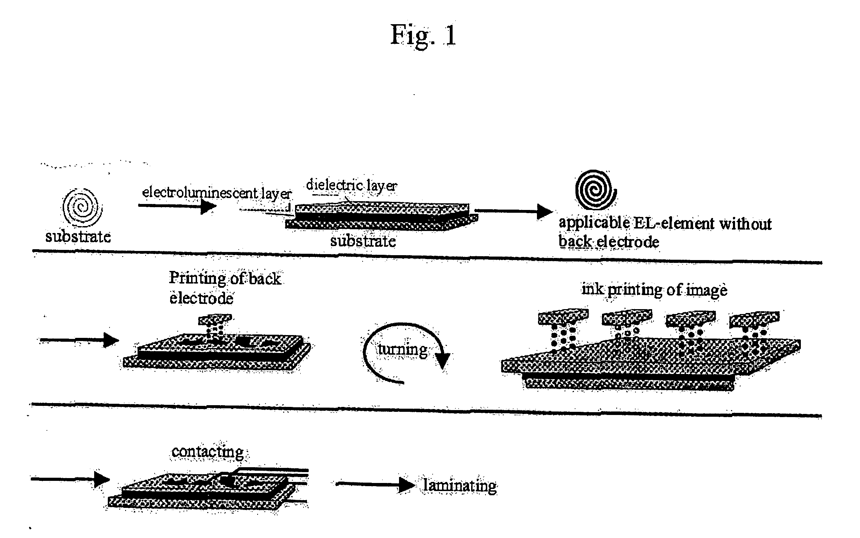

In Fig. 1 a preferred embodiment of the present invention is described, showing the respective method steps for obtaining an electroluminescent display according to the present invention.

According to the present invention an electroluminescent display is provided, comprising several layers disposed on each other. Starting from a substrate, an electroluminescent layer is disposed on a first side of the substrate. Onto said electroluminescent layer in turn a dielectric layer is applied and a back electrode, above said dielectric layer, is ink jet printed. On the second side of the substrate an image consisting of ink is formed by means of ink jet printing. The ink used for the printing of the second side of the substrate may be for example a UV curing ink. Preparation, application and curing of such an ink represent techniques all well known to the person skilled in the art.

The substrate to be used in the present display may be any device in a form allowing passage through a printing device. In principle, the material of the slide may be any suitable material known to the skilled person, preferably polyethylene (PE) or polypropylene (PP) and the substrate may have a thickness of from about 20 µm to about 300 µm. Preferably, the thickness is of from about 30 µm to about 250 µm, more preferably from about 50 µm to about 150 µm and still more preferably from about 75 µm to about 100 µm. Said substrate may be a slide having doted or not-doted indiumtinoxide (ITO) disposed thereon. The ITO-slide may be prepared according to any technique well known to the skilled person, such as vacuum deposition, sputtering or a sol-gel-technique.

The electroluminiscent layer disposed on one side (the first side) of the substrate comprises materials suitable for the preparation of electroluminescent layers, such as for example zinksulfide (ZnS), silicon, germanium or a semiconductor such as InP, GaAs, GaAlAs, GaP or GaN with suitable dopants, preferably zinksulfide. The thickness of this layer is generally in the range of from about 1 µm to about 30 µm. Preferably, the thickness is in the range of from about 5 µm to about 25 µm, more preferably from about 15 µm to about 20 µm.

The dielectric layer, arranged above the electroluminiscent layer with respect to the substrate may comprise a high-dielectric material, such as barium or strontium titanate, barium-strontium titanate or titania, mixed with a dielectric resin binder, such as a vinylidene copolymer. Preferably barium titanate is used for the preparation of the dielectric layer. The thickness of this layer is generally in the range of from about 1 µm to about 30 µm. Preferably, the thickness is in the range of from about 5 µm to about 25 µm, more preferably from about 15 µm to about 20 µm.

Both, the electroluminescent layer and the dielectric layer may be prepared and layered on the substrate/the layer underneath by means of conventional techniques, well known to the skilled artisan, such as silk-screen-techniques.

On top of the dielectric layer a back electrode is arranged, which may comprise a conductive polymer organic layer, which may be selected from the group consisting of poly-3,4-ethylenedioxythiophene (PEDOT), polyaniline (PANI), or carbazole-based, arylamine-based, perylene-based, pyrrole-based and oxadiazole-based derivatives or similar materials. Preferably the material of the polymer organic layer is PANI. The back electrode is provided with suitable means, such as e.g. electrical contacts, in order to apply electric current and to illuminate the electroluminescent display. If different areas are arranged with a back electrode various circuits may be established, in order to ensure power supply for each of said areas.

The ink used for the printing of the second side of the substrate may be any kind of ink, for example a water-based ink, a solvent-based ink or UV-curing ink. In case a water-based ink is used, the second side of the substrate preferably exhibits a certain porosity of the material to ensure adhesion, whereas solvent-based ink or UV-curing ink do not require any particular structure of the surface of the second side of the substrate. The term solvent shall designate any organic solvent, such as ethanol. Preparation, application and curing of such types of ink represent techniques all well known to the person skilled in the art. Preferably, a UV-curing ink is used.

In a preferred embodiment of the present invention said substrate is a slide having doted or not-doted indiumtinoxide (ITO) disposed thereon. The material of the slide may be any suitable material known to the skilled person, preferably polyethylene (PE) or polypropylene (PP). The ITO-slide may be prepared according to any technique well known to the skilled person, such as vacuum deposition, sputtering or a sol-gel-technique.

According to a preferred embodiment of the present invention said electroluminescent layer is preferably zinksulfide.

According to another preferred embodiment of the present invention the dielectric layer comprises barium titanate.

According to a particular embodiment, said back electrode is a conductive polymer organic layer, which is preferably selected from the group consisting of poly-3,4-ethylenedioxythiophene (PEDOT), polyaniline (PANI), or carbazole-based, arylamine-based, perylene-based, pyrrole-based and oxadiazole-based derivatives or similar materials. More preferably the material of the polymer organic layer is PANI.

According to still another embodiment of the present invention said back electrode and/or said image are provided with a lamination thereon for means of protecting against detrimental environmental influences, such as weather but also scratching.

The ink forming the back electrode is applied in particular patterns on the surface of the dielectric layer. Preparation and constituents of the ink are described hereinafter.

According to another embodiment of the present invention an ink for printing of a back electrode is provided. The ink comprises a base solvent, a humectant, a co-solvent and a conductive material. The constituents are included in certain amounts. In particular, the base solvent is contained in the range of from 10 to 90 % by weight, preferably in the range of from 50 to 90 % by weight and more preferably in the range of from 80 to 90 % by weight. The humectant is contained in the range of from 1 to 20 % by weight, preferably in the range of from 1 to 10 % by weight and more preferably in the range of from 1 to 5 % by weight. The co-solvent is contained in the range of from 1 to 30 % by weight, preferably in the range of from 1 to 15 % by weight and more preferably in the range of from 1 to 10 % by weight. The conductive material is contained in the range of from 0.1 to 20 % by weight, preferably in the range of from 0.1 to 5 % by weight and more preferably in the range of from 1 to 2 % by weight.

The constituents, namely the base solvent, humectant and co-solvent, are used to give the ink the desired properties, such as viscosity and surface tension, in order to prevent the ink from drying out or crusting in the nozzles of an inkjet print head, to aid solubility of the constituents and to facilitate penetration as well adhesion of the ink to a the dielectric layer after printing. The base solvent may be water or any suitable organic solvent, whereas humectant and co-solvent are organic solvents.

Examples of such organic solvents/compounds used in ink compositions may include alcohols, such as methyl alcohol, ethyl alcohol, n-propyl alcohol, isopropyl alcohol, n-butyl alcohol, sec-butyl alcohol, t-butyl alcohol, iso-butyl alcohol, furfuryl alcohol, and tetrahydrofurfuryl alcohol; polyhydric alcohols, such as ethylene glycol, diethylene glycol, triethylene glycol, tetraethylene glycol, propylene glycol, polyethylene glycol, glycerol, 2-methyl-2,4-pentanediol, 1,2,6-hexanetriol, 2-ethyl-2-hydroxymethyl-1,3-propanediol, 1,5-pentanediol, 1,2-hexanediol, and thioglycol; lower mono- and di-alkyl ethers derived from the polyhydric alcohols; nitrogen-containing compounds such as urea, 2-pyrrolidone, N-methyl-2-pyrrolidone, and 1,3-dimethyl-2-imidazolidinone; and sulfur-containing compounds such as 2,2'-thiodiethanol.

An advantage of the ink used resides in its short curing periods and high adhesion strength after application on the dielectric layer. Another advantage of the present invention resides in that such displays may be also produced by a user or customer himself, merely requiring a common ink jet printer without the need of any other particular devices. In particular, the customer may purchase already prepared substrates having an electroluminescent material and a dielectric layer disposed thereon. In such a case, the customer merely has to print the pattern of the back electrode with, for example, his own printer. The remaining steps of printing the image on the second side of the substrate and optionally contacting as well as laminating may be also performed by the customer himself as indicated in Fig. 1.

According to still another embodiment of the present invention the ink for printing of a back electrode contains a surfactant in the range of from 0.1 to 5 % by weight, preferably in the range of from 0.5 to 2 % by weight and more preferably in the range of from 1 to 1.5 % by weight.

According to a preferred embodiment of the present invention the ink for printing of a back electrode contains a binder in the range of from 0.1 to 10 % by weight, preferably in the range of from 0.5 to 4 % by weight and more preferably in the range of from 1.5 to 2 % by weight.

According to another preferred embodiment of the present invention a method for the preparation of an electroluminescent display is provided, comprising the steps of:
(a) Applying an electroluminescent layer on a first side of a substrate;
(b) Applying a dielectric layer on said electroluminescent layer;
(b) Ink jet printing of a back electrode on said dielectric layer;
(c) Printing ink in form of an image on the second side of the substrate.

According to still another embodiment of the present invention the method comprises the additional step (d) of contacting. The term "contacting" is directed to the provision of electrical contacts to selected areas of the back electrode in order to apply electric current and to illuminate the electroluminescent display.

According to another embodiment of the present invention on the back electrode provided with electric contacts and/or the printed image a laminate may be applied in order to protect the respective surfaces from environmental influences.

### Examples:

A commercially available ITO polyester sheet as front electrode is coated by screen printing with a homogenous layer of ZnS (purchased by Ormecon, EL5400) (screen 62) and a layer of dielectricum (EL5500) (screen 90). The base layers are dried at °C for 30 min. and are used as carrier for the back electrode. The ink, which acts as back electrode (composite of PANI) is filled in a cartridge of an EPSON Stylus 1200 Inkjet Printer. The carrier is then fed in the printer and the desired motif is printed. After contacting of the back electrode and energy supply to the circuits, the printed area is illuminated. The other side, the first side of the substrate, is imprinted with a normal, commercially available ink.

## Claims

1. An electroluminescent display, comprising:
(a) a substrate having a first and a second side,
(b) an electroluminescent layer on said first side of the substrate,
(c) a dielectric layer on said electroluminescent layer;
(d) an ink jet printed back electrode on said dielectric layer, and
(e) an image on said first side of said substrate, wherein
said image consists of ink.

2. The electroluminescent display according to claim 1, wherein said substrate is an ITO-slide.

3. The electroluminescent display according to any of the preceding claims, wherein said electroluminescent layer consists zinksulfide.

4. The electroluminescent display according to any of the preceding claims, wherein said dielectric layer consists of barium titanate.

5. The electroluminescent display according to any of the preceding claims, wherein said back electrode is a polymer organic layer.

6. The electroluminescent display according to any of the preceding claims, wherein said polymer organic layer is selected from the group consisting of PEDOT, PANI, or carbazole-based, arylamine-based, perylene-based, pyrrole-based and oxadiazole-based derivatives or similar materials.

7. The electroluminescent display according to any of the preceding claims, wherein said back electrode is provided with electrical contacts.

8. The electroluminescent display according to claim 7, wherein said back electrode provided with electrical contacts is laminated.

9. The electroluminescent display according to any of the proceeding claims, wherein said image is laminated.

10. An ink for printing a back electrode, comprising:
a base solvent in the range of from 10 to 90 % by weight;
a humectant in the range of from 1 to 20 % by weight;
a co-solvent in the range of from 1 to 30 % by weight; and
a conductive material in the range of from 0.1 to 20 % by weight.

11. The ink according to claim 10, comprising a surfactant in the range of from 0.1 to 5 % by weight.

12. The ink according to claim 10 or 11, comprising a binder in the range of from 0.1 to 10 % by weight.

13. A method for the preparation of an animated electroluminescent display, comprising the steps of:
(a) applying an electroluminescent layer on a first side of a substrate;
(b) applying a dielectric layer on said electroluminescent layer;
(b) ink jet printing of a back electrode on said dielectric layer; and
(c) printing ink in form of an image on the second side of the substrate.

14. The method according to claim 10, comprising an additional step (d) of contacting.

15. The method according to any of the claims 10 to 11, comprising an additional step (e) of laminating.
